# EUROPEAN PATENT APPLICATION

(11) **EP 4 576 159 A1**
(43) Date of publication of application: **25.06.2025**
(21) Application number: 23218424.2
(22) Date of filing: 20.12.2023
(51) Int. Cl.: H01J 37/28, H01J 37/18

(54) **CHARGED PARTICLE SYSTEM AND METHOD OF BAKING OUT A CHARGED PARTICLE SYSTEM**

(71) Applicant: ASML Netherlands B.V., 5500 AH Veldhoven (NL)
(72) Inventor: WESTERHUIS, Evert, Auke, Rinze, 5500 AH Veldhoven (NL); STEUNEBRINK, Martin, 5500 AH Veldhoven (NL); VEENSTRA, Roy, Ramon, 5500 AH Veldhoven (NL); VAN SOEST, Jurgen, 5500 AH Veldhoven (NL); LOOMAN, Bram, Albertus, 5500 AH Veldhoven (NL); DE LANGEN, Johannes, Cornelis, Jacobus, 5500 AH Veldhoven (NL); SCHUURBIERS, Koen, 5500 AH Veldhoven (NL); XI, Qing Po, San Jose, CA 95134 (US); DEL TIN, Laura, 5500 AH Veldhoven (NL)
(74) Representative: ASML Netherlands B.V.

(57) **Abstract**

The present disclosure relates to a charged particle system for emitting a beam of charged particles towards a sample for inspecting the sample. The system comprises: a source, a charged particle device, a support, a vacuum system, and a thermal control system. The source is configured to emit a beam of charged particles. The charged particle device is configured to project the beam of charged particles towards a sample. The charged particle device comprises a plurality of charged particle-optical elements along the path of the beam of charged particles. The support is configured to support the sample. The vacuum system includes a plurality of chambers of which different chambers are configured to comprise at least one respective component. The at least one respective component comprises at least one of the source and one or more charged particle-optical element. The thermal control system configured to bake out the different chambers independently.

## Description

### FIELD

The embodiments provided herein generally relate to a system for directing charged particles such as electrons towards a sample and related apparatus and methods.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incident particles or other processing steps such as etching, deposition or chemical mechanical polishing. Monitoring the extent of the undesired pattern defects is therefore an important process in the manufacture of IC chips. More generally, the assessment (e.g. inspection and/or measurement) of a surface of a substrate, or other object/material, is an important process during and/or after its manufacture.

Pattern assessment systems for example pattern inspection tools with a charged particle beam of charged particles have been used to assess objects, for example to detect pattern defects. The charged particles are often electrons. These systems typically use electron microscopy techniques, such as a scanning electron microscope (SEM). In a SEM, a primary electron beam of electrons at a relatively high energy is targeted with a final deceleration step to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, signal electrons can be emitted from the surface of the target. By collecting these emitted signal electrons from the target surface, a pattern inspection tool (or apparatus) may obtain an image-like signal representing characteristics of the material structure of the surface of the target.

Due to the small dimensions and specific materials of certain components, of such assessment systems such as this can be sensitive to failures caused by contamination. One way to reduce the level of contamination is to bake out the system by bringing the components to an elevated temperature to increase the rate of evaporation of contamination. This can result in a significant amount of downtime while the system is being baked out to remove contamination and restore the assessment system to a sufficient level of performance. During the downtime sample assessment cannot be performed using the assessment system.

### SUMMARY

It is an object of the present disclosure to provide a system and method for reducing contamination in a time-efficient manner.

According to an aspect of the invention, there is provided a charged particle system for emitting a beam of charged particles towards a sample for inspecting the sample. The system comprises: a source, a charged particle device, a support, a vacuum system, and a thermal control system. The source is configured to emit a beam of charged particles. The charged particle device is configured to project the beam of charged particles towards a sample. The charged particle device comprises a plurality of charged particle-optical elements along the path of the beam of charged particles. The support is configured to support the sample. The vacuum system includes a plurality of chambers of which different chambers are configured to comprise at least one respective component. The at least one respective component comprises at least one of the source and one or more charged particle-optical element. The thermal control system configured to bake out the different chambers independently.

According to an aspect of the invention, there is provided a method of baking out a charged particle system. The charged particle system comprises: a source configured to emit a beam of charged particles; a charged particle device configured to project the beam of charged particles towards a sample, the charged particle device comprising a plurality of charged particle-optical elements along the path of the beam of charged particles; a vacuum system with a plurality of chambers of which different chambers comprise at least one respective component comprising at least one of the source and one or more charged particle-optical elements; and a thermal control system configured to bake out the different chambers. The method comprises controlling the thermal control system to bake out different chambers independently.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary assessment apparatus.
**FIG. 2** is a schematic diagram illustrating an exemplary multi-beam charged particle assessment system that is part of the exemplary electron beam assessment apparatus of **FIG. 1****.**
**FIG. 3** is a schematic diagram illustrating a charged particle system comprising a thermal control system.
**FIG. 4** is a schematic diagram illustrating a charged particle system comprising a thermal control system including heaters disposed in the walls of a plurality of chambers.
**FIG. 5** a schematic diagram of an exemplary electron-optical system comprising a macro collimator and macro scan deflector.
**FIG. 6** is a schematic diagram illustrating an exemplary multi-beam charged particle-optical device that is part of the exemplary assessment apparatus of **FIG. 1****.**
**FIG. 7** is a schematic diagram of an alternative exemplary charged particle-optical device that is part of the exemplary assessment apparatus of **FIG. 1****.**
**FIG. 8** is a schematic diagram of an exemplary multi-beam charged particle device.
**FIG. 9** is a schematic diagram of an exemplary charged particle-optical device array comprising a plurality of charged particle-optical devices.
**FIG. 10** is a schematic diagram of a charged particle apparatus including a charged particle device.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a SEM) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of charged particle-optical apparatus embodying these scanning electron microscope features may have a single beam. For higher throughput such as for assessment, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam assessment apparatus may therefore assess a target much quicker, e.g. by moving the target at a higher speed, than a single-beam assessment apparatus.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

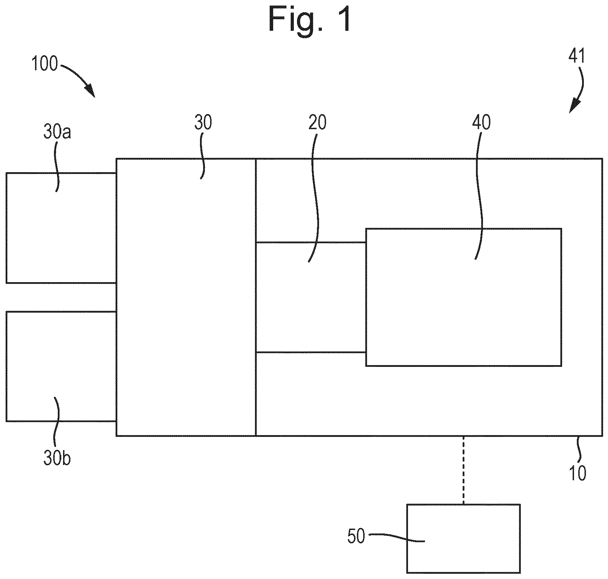

Reference is now made to **FIG. 1****,** which is a schematic diagram illustrating an exemplary assessment apparatus 100, e.g. an inspection apparatus. The assessment apparatus 100 of **FIG. 1** includes a vacuum chamber 10, a load lock chamber 20, a charged particle-optical apparatus, an equipment front end module (EFEM) 30 and a controller 50. The charged particle device 41 may be within the vacuum chamber 10. The electron-optical apparatus may comprise a charged particle device 41 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the charged particle device 41 by which it may be assessed. A charged particle device 41 may comprise either a single beam or a multi-beam charged particle-optical apparatus.

The controller 50 is electronically connected to the charged particle system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing a charged particle-optical device. Rather, it is appreciated that the foregoing principles may also be applied to other apparatuses and other arrangements of apparatus that operate under the second pressure.

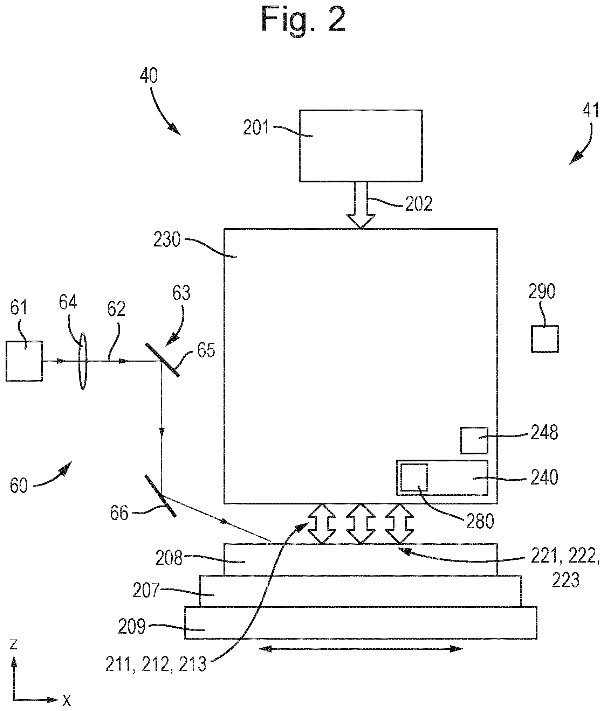

Reference is now made to **FIG. 2****,** which is a schematic diagram illustrating an exemplary charged particle system 40 including a multi-beam charged particle device 41 that is part of the exemplary charged particle beam assessment apparatus 100 of **FIG. 1****.** The multi-beam charged particle device 41 comprises an electron source 201 and a projection apparatus 230. The charged particle system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. Such scanning may be controlled by the controller 50 to cooperate with a simultaneous scanning movement of the actuated stage 209. In response to incidence of the primary sub-beams 211, 212, and 213 on the probe spots 221, 222, and 223 on the sample 208, signal electrons are generated from the sample 208 which include secondary electrons and backscattered electrons. The secondary electrons typically have electron energy ≤ 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle system 40 such as the detector 240 (as shown in **FIG. 2**)**.** However, the signal processing system 280 may be incorporated into any components of the assessment apparatus 100 or multi-beam charged particle system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

As mentioned, the controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle system 40 and charged particle beam assessment apparatus 100 described above, are disclosed in US2020118784, US20200203116, US 2019/0259570 and US2019/0259564 which are hereby incorporated by reference.

As shown in **FIG. 2****,** in an embodiment the charged particle system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

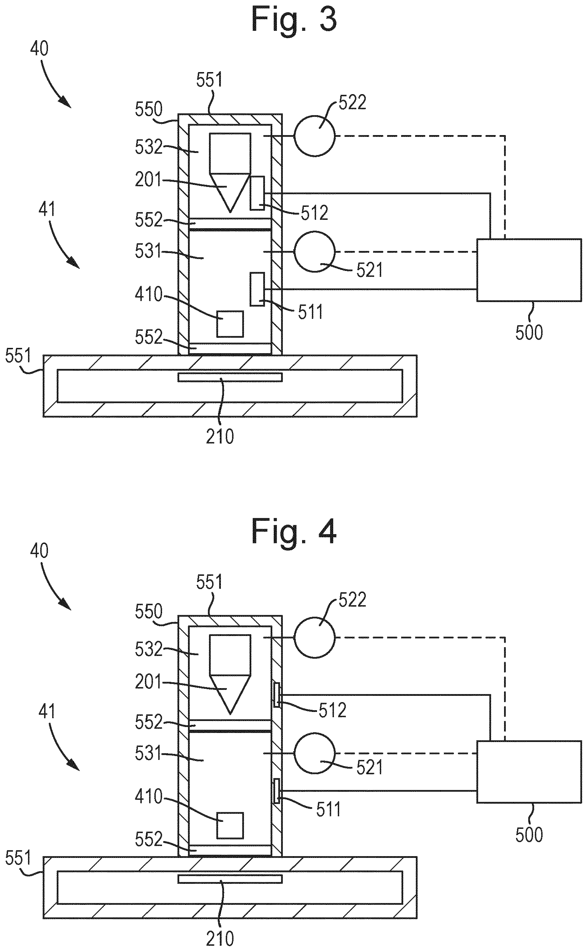

Components of a charged particle system 40 which may be used in the present invention are described below in relation to each and all of **FIGs. 3 to 9** which are schematic diagrams of a charged particle system 40. The charged particle system 40 of the arrangements shown in these figures may correspond to the charged particle system 40 (which may also be referred to as an apparatus or a tool) mentioned above.

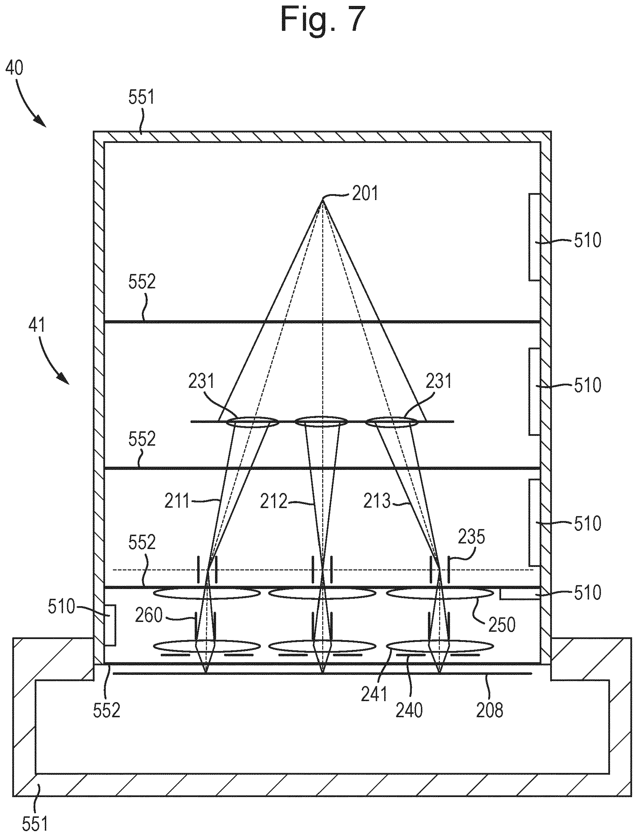

Considering the arrangement as shown in **FIG. 7** the electron source 201 directs electrons toward an array of condenser lenses 231 (otherwise referred to as a condenser lens array). The electron source 201 is desirably a high brightness emitter arranged to operate within an optimized electron-optical performance range that is a compromise between brightness and total emission current (such a compromise may be considered to be a 'good' compromise). The electron source emits a source beam. There may be many tens, many hundreds or many thousands, or even tens of thousands of condenser lenses 231. The condenser lenses 231 may comprise multi-electrode lenses and have a construction based on EP1602121A1, which document is hereby incorporated by reference in particular to the disclosure of a lens array to split a source beam into a plurality of sub-beams. A most upbeam plate, which may be referred to as beam limiting aperture array, and which may be the most upbeam plate of the condenser lens array, may generate the plurality of beams. The array condenser lenses (which may comprise the beam limiting aperture array) may provide a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens 231 in the array directs electrons into a respective sub-beam 211, 212, 213 which is focused at a respective intermediate focus downbeam of the condenser lens array. The sub-beams diverge with respect to each other. In an embodiment, collimators such as deflectors 235 are provided at the intermediate focuses. The collimators are positioned in the sub-beam paths at, or at least around, the position of the corresponding intermediate points of focus. The collimators are positioned in or close to the sub-beam paths at the intermediate image plane of the associated sub-beam. The collimators are configured to operate on the respective sub-beams 211, 212, 213. The collimators are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The collimators (e.g. deflectors 235) may also be referred to as collimator deflectors. The deflectors 235 in effect collimate the paths of the sub-beams so that before the deflectors, the sub-beam paths with respect to each other are diverging. Downbeam of the collimators the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. In an embodiment of the arrangement, the collimator may comprise a macro collimator, instead of, or in addition to the deflectors 235. The macro-collimator may be electrostatic for example as two more planar plates with a single aperture.

Below (i.e. downbeam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching an objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. In an embodiment the control lenses of the control lens array may be considered to be part of the objective lenses of the objective lens array. The electrode plates of the control lens array may be considered electron-optically to be additional electrode plates of the objective lens array.

It is desirable to use the control lens array 250 to determine the landing energy. However, it is possible to use in addition the objective lens array 241 to control the landing energy. In such a case, a potential difference over the objective lens is changed when a different landing energy is selected. However, using the objective lens instead of the control lens to determine the landing energy may be less desirable in view the impact of the impact on the focal length because the focal length of the objective lens roughly scales with the landing energy used.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned upbeam of the objective lens array 241.

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The objective lens array 241 may be positioned at or near the base of the charged particle device 41. The control lens array 250 is optional, but is preferred for optimizing a sub-beam upbeam of the objective lens array. In an arrangement the control lens array 250 may be considered to be part of the objective lens array. The plates of the control lens array may be considered to be additional plates of the objective lens array. Within an objective lens array meeting this definition the function of the control lens array may be a function of the objective lens array in addition to the functions of the objective lens array herein described.

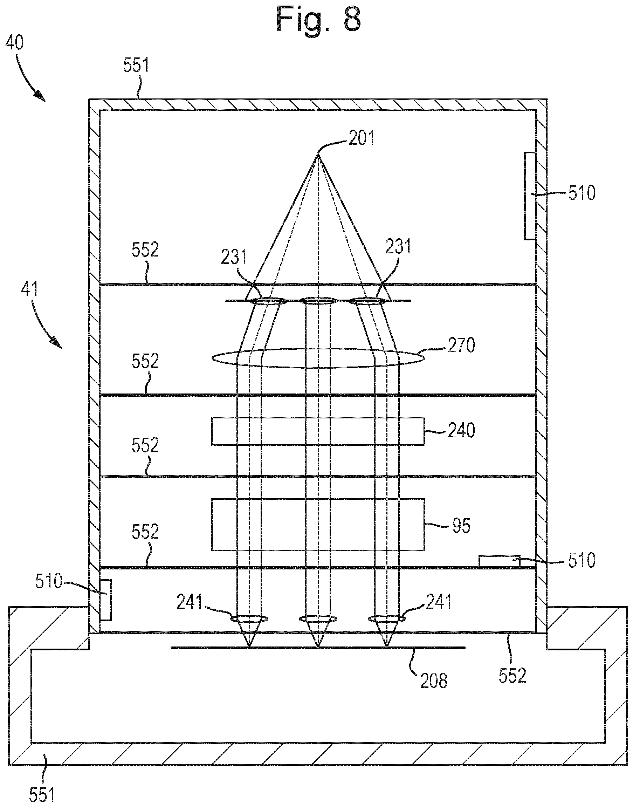

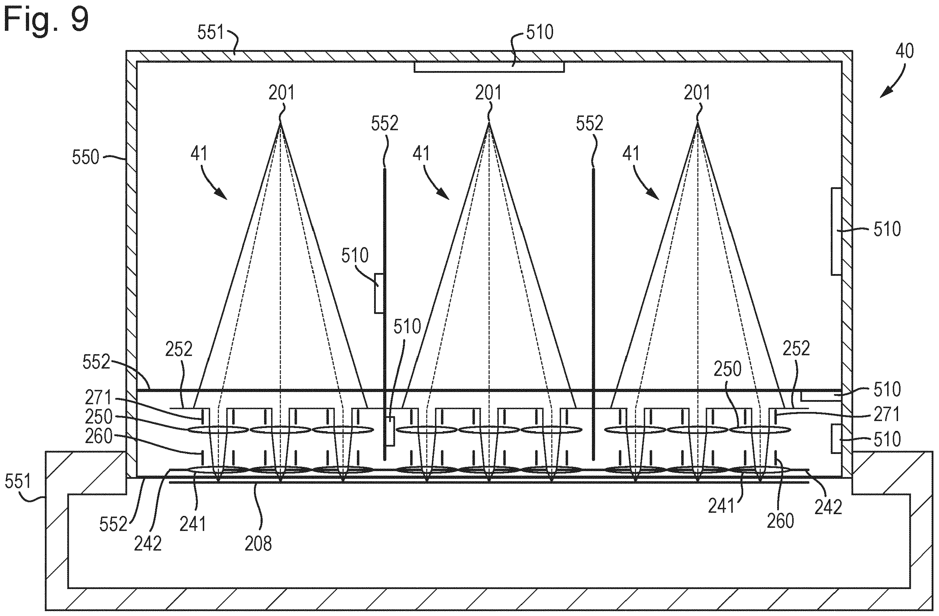

For ease of illustration, lens arrays are depicted schematically herein by arrays of oval shapes (as shown in **FIG. 7** and for that matter **FIGs 8** **and** **9**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

An array of scan deflectors 260 may be provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

Due to the small dimensions and specific materials of the components, charged particle assessment systems (e.g. the charged particle system 40 as described above) can be sensitive to failures caused by contamination. One way to reduce the level of contamination is to bake out the system by bringing the components to an elevated temperature to increase the rate of evaporation of contamination. This can result in a significant amount of downtime to bake out for sufficient time to decontaminate the components.

There are several different ways to perform bake out. For example, individual components may be removed from the system and baked out in an oven. However, removing components for bake out in an oven takes a lot of time for disassembly and reassembly. Furthermore, this method is limited for use on only certain, readily accessible and removable components. Moreover, the process of disassembly and reassembly can be an additional source of contamination by introducing particles to the system. Opening the system for the assembly and disassembly may also negatively affect aspects such as alignment of components within the system, such as electron-optical components. Opening the system may permit ingress of unwanted contamination borne in the ambient atmosphere. The process of disassembly, removing components, performing bake out on the removed components, and reassembly can take several months, during which the charged particle system 40 cannot be used to perform assessment.

Another way or approach to perform bake out involves fitting the charged particle system 40 with externally applied temperature-controlled heaters for example with depressurized vacuum chambers (i.e. a released vacuum towards the ambient pressure) and covering the charged particle assessment system with insulating blankets. In this way, the system may be brought to partially elevated temperatures. This approach has an effect in removing contamination (i.e. cleaning), but provides no means to directly control the temperatures of the specific components, and/or surfaces for example during such cleaning. As such, it can be desirable to first remove heat sensitive components which may be damaged by high temperatures. This bake out method may take a day or two (e.g. 24 to 48 hours), in addition to time needed to remove heat sensitive components, set-up and remove the temperature-controlled heaters and insulating blankets, and re-install the heat sensitive components. This can have a detrimental impact on the availability of the charged particle system 40.

Furthermore, due to lack of control over the surface temperatures within the system, the effectiveness of the bake out is uncertain. Thus, often a longer period of bake out is applied to ensure sufficient decontamination. The duration of the bake out is so long that it is undesirable to perform back outs frequently. As such, longer periods of time may be left between bake outs, such that higher levels of contamination may accumulate, increasing the risk of failures.

**FIG. 3** shows a schematic illustration of a charged particle system 40, such as the charged particle system described above with reference to **FIG. 1** **and** **2****,** for emitting a beam of charged particles towards a sample for inspecting the sample. The charged particle system 40 of **FIG. 3** comprises a source 201, a charged particle device 41, a support 210, a vacuum system and a thermal control system. The source 201 is configured to emit a beam of charged particles, for example in the manner described above with reference to the source 201 of **FIG. 2****.** The charged particle device 41 may be a charged particle device 41 as described above with reference to **FIG. 1** **and** **2****.** The charged particle device 41 is configured to project the beam of charged particles towards the sample. In an alternative configuration, the source 201 may be considered as a component of the charged particle device 41. In other words, the charged particle device 41 may optionally comprise the source 201. The charged particle device 41 comprises a plurality of charged particle-optical elements 410 along the path of the beam of charged particles. The support 210 is configured to support the sample. The support 210 may be disposed on a stage 209, for example the support 210 may comprise or consist of a sample holder 207, such as described above with reference to **FIG. 2****.** Alternatively, the support 210 may be comprised of a stage 209, such as an actuated stage 209 as described above with reference to **FIG. 2****.**

The charged particle system 40 of **FIG. 3** comprises a vacuum system. In other words, the charged particle system 40 is configured such that, during use, at least some regions of the system are at a pressure lower than atmospheric pressure. In particular, the vacuum system comprises a plurality of chambers 531, 532. One or more of the plurality of chambers may be a vacuum chamber 10 as described above with reference to **FIG. 1****.** The volume defined by the vacuum chamber 10 may be considered to be one more regions. The different chambers are configured to comprise at least one respective component comprising at least one of the source 201 and one or more charged particle-optical elements 410. In other words, the vacuum system comprises at least two chambers. The different chambers comprise different components of the source and charged particle device, so that at least one chamber comprises the source or a charged particle optical element and another chamber comprises a charged particle element that is different from the one if the first chamber (if present). For example, in the arrangement of **FIG. 3****,** the vacuum system comprises a first chamber 531 and a second chamber 532. The first chamber 531 comprises, or houses, a plurality of charged-particle optical elements 410. The second chamber 532 comprises, or houses, the source 201. In an alternative arrangement, there may be one or more further chambers and one of more charged-particle optical elements may be comprised within the one or more further chambers. Additionally, or alternatively, the source 201 may be comprised within the same chamber as one or more of the charged-particle optical elements of the charged particle device 41. The vacuum system may comprise a vacuum chamber configured to comprise one or more parts of the projection system 60 shown in **FIG. 2****.** Additionally, or alternatively, one or more parts of the projection system 60 may be comprised within the same chamber as one or more of the charged-particle optical elements of the charged particle device 41.

The thermal control system of the charged particle system 40 is configured to bake out the different chambers independently and optionally simultaneously. In other words, the thermal control system is configured to achieve bake out in each chamber independently. In particular, a temperature of one chamber may be raised to achieve bake out locally in that one chamber. In this way, it may be possible to locally bake out a single chamber, or even to locally bake out a particular component within a single chamber. The thermal control system may be configured such that bake out of one chamber does not significantly influence the temperature of an adjacent chamber. For example, in the arrangement of **FIG. 3****,** the thermal control system may be used to achieve bake out in first chamber 531, without simultaneously achieving bake out in the second chamber 532. With this arrangement, bake out may be performed in a manner which is efficient in both time and energy. Energy may not be wasted on heating chambers and associated components which do not require bake out at that time, or at such high temperatures. Meanwhile, time may not be wasted with removing more heat sensitive components, if those components are in a chamber which is not being baked out. Consequently, there may be significant savings in time and reduction in downtime of the system for bake out when an arrangement such as that described above in reference to **FIG. 3** is used. Bake out may be applied to components selectively. Some parts of the charged particle system 40 may be baked out more often or frequently than others for example to maintain the operational condition of the respective parts of the charged particle system. By having the different parts in different vacuum chambers enables the components and parts of the charged particle system to undergo bake out separately and even independently of each other. This may enable bake out, particularly of the most critical or commonly contaminated components, to be performed more frequently, reducing the risk of failures which may otherwise result in even further increases in downtime. Note, even though bake out can be implemented in different regions independently, on occasion multiple chambers or even all the chambers of the charged particle system 40 may be baked out simultaneously.

Furthermore, performing bake out in a targeted local region of the system, rather than on larger regions such as on the charged particle system 40 or charged particle device 41 as a whole, may enable more targeted use of temperature. As an example, a global bake out of the vacuum system may take several days at a temperature of approximately 100 °C. In such a global bake out, it may not be possible to significantly increase the temperature because some components within the vacuum system may be too heat sensitive to survive higher temperatures. Providing a plurality of chambers and a temperature control system capable of independently controlling temperature, and bake out, in the different chambers, it may be possible to bake out some chambers at higher temperatures, such as 250 to 300 °C, without risking damage to the more thermally sensitive components in other chambers. The use of higher temperature for targeted bake out in certain chambers containing certain components, may enable these chambers/components to undergo bake out more quickly than if bake out were performed at a lower temperature. For example, instead of being baked out for several days at 100 °C, the same decontamination effect may be achieved by baking out for a few hours at 250 °C. Thus, the bake out of some key components or chambers may be performed significantly more quickly, reducing downtime. This means that, if desired, the bake out of these components may be performed more frequently, reducing the risk of failures and the need to replace parts.

As shown in **FIG. 3****,** the thermal control system comprises a thermal conditioner, in this case a heater 511, 512, associated with a corresponding chamber of the vacuum system. The thermal conditioner is configured to alter the temperature of the corresponding chamber. The thermal conditioner may comprise a heater and/or a cooling element. Such a heater may apply heat to a component of the charged particle system in the vacuum chambers 531, 532. Such a cooling element may be used to regulate or temper the heat load applied to a different component or a different part of the component to which the heat load of the heater is applied. Such a cooling element may be used to shield or protect a sensitive part or element of the component or a different component within the chamber from excessive temperatures. Such an excessive temperature above a temperature threshold may cause deterioration to the integrity and/or function of the sensitive part or element. It is desirable that at least one thermal conditioner is associated with each chamber which may require bake out. For example, each chamber may be associated with at least one corresponding element such as a heater and/or cooling element, possibly a plurality of corresponding heaters, configured to heat that chamber.

The heater is desirably configured to heat at least part of at least one respective component within the corresponding chamber. The at least part of the at least respective component is desirably heat resistant. In other words, the heater may be disposed on, adjacent to, or within at least part of the at least one respective component. The part of the at least one component which is heat resistant is desirably able to withstand temperatures of, for example, 100 °C, desirably 200 °C, more desirably 250 °C, yet more desirably 300 °C. For example, the part of the at least one component which is heat resistant may comprise or consist of ceramic or silicon or quartz.

The thermal control system may be used to control the heater to locally bake out at least part of the at least one respective component. This may provide for even more locally targeted bake out within the corresponding chamber. For example, a plurality of heaters may optionally be provided to correspond to different respective components within the same corresponding chamber. In this way, high temperature bake out may be performed on particular components while maintaining a slightly lower temperature in the rest of the chamber, and without necessitating simultaneous bake out of any adjacent chambers. The at least one respective component may comprise at least one of: the source 210, the support 210, and at least one of the charged particle-optical elements 410. Thus two or more components of a vacuum chamber may be locally heated. For example, in the charged particle system of **FIG. 3****,** the at least one respective component of the first chamber 531 is at least one of the charged particle optical elements 410, and the at least one respective component of the second chamber 532 is the source 201. As shown, for example, in **FIG. 3****,** the source 201 is desirably in a different chamber than the one or more charged particle-optical elements 410.

In the arrangement of **FIG. 3****,** a first heater 511 is associated with the first chamber 511, and a second heater 512 is associated with the second chamber 532. The first heater 511 is configured to increase the temperature of the first chamber 531 when the thermal control system initiates bake out of the first chamber 511. The second heater 512 is configured to increase the temperature of the second chamber 531 when the thermal control system initiates bake out of the second chamber 532. The thermal conditioner may be directly connected to the corresponding chamber in order to adjust the temperature of the corresponding chamber. As shown, for example, in **FIG. 3****,** the heater 511, 512 may be disposed within an interior of the corresponding chamber 531, 532 of the vacuum system. The interior of the corresponding chamber may be defined by an interior surface of a wall 550 defining the corresponding chamber.

In an alternative arrangement, the thermal conditioner (e.g., the heater) may be at least partially embedded within a wall defining the corresponding chamber of the vacuum system. For example, the thermal conditioner may flush with an interior surface of the wall defining the corresponding chamber. In other words, an innermost surface of the thermal conditioner, facing an interior of the corresponding chamber, may form a flat plane with the interior surface of the wall 511 defining the corresponding chamber.

**FIG. 4** depicts a charged particle system 40 similar to that described above with respect to **FIG. 3****.** All features of **FIG. 4** having the same numerals are intended to be the same as described above in reference to **FIG. 3****.** The arrangement of **FIG. 4** differs from that of **FIG. 3** only in the placement of the heaters 511, 512. In the arrangement of **FIG. 3****,** as described above, the heaters 511, 512 are disposed within the corresponding chambers 531, 532. The arrangement of **FIG. 4** similarly comprises the first heater 511 associated with the first chamber 531, and the second heater 512 associated with the second chamber 532. However, the heaters 511, 512 of **FIG. 4** are completely embedded within the wall 550 defining the respective corresponding chambers 531, 532 of the vacuum system.

In an alternative arrangement, the thermal control system may comprise a plurality of heaters. One or more of the heaters may be within a corresponding chamber. One or more of the heaters may be within a wall defining a corresponding chamber. One or more of the chambers may be associated with a plurality of corresponding heaters. In other words, a plurality of heaters may be associated with the same corresponding chamber. Each of the plurality of heaters may be provide within the same corresponding chamber. Alternatively, one or more of the plurality of heaters may be embedded in a wall (such as an interior or exterior wall) defining the corresponding chamber.

In some arrangements, a thermal conditioner, such as a heater, may be disposed on, adjacent or within at least part of the at least one respective component within the corresponding chamber. For example, a localized thermal conditioner, such as a resistive trace or a fluid conduit, may be provided within a component, such as an electron-optical component, of the charged particle device 41. A component may serve multiple purposes and act as a localized thermal conditioner in addition to serving a further purpose (or vice versa). For example, a such components have parts that may include: connectors, feedthroughs, flexes and potting. A flex or printed circuit board (PCB) is usually for providing electrical connections between different parts of a component. Such a PCB is also an example for a mount of an electronics or other electrical components in the charged particle system. A resistive trace may be provided within such a connector or mount, for example a flex and/or a PCB, in order to perform a heating function as required. Such a trace may be an existing electrical connection or wire, or additional connector or wire. The part of the component (and thus the component) may comprise plastic and a metal e.g. copper, such as copper wire. Some of these materials are a greater source of contamination which may sometimes be referred to as outgassing. Such a source of contamination is for example plastic and ceramic. During bake out plastic is heated up to force out the contamination. Such contamination may be referred to outgassing. Outgassing materials include water and hydrocarbons for example in the form of gas. The resistive trace may generate heat when conducting current. Alternatively, or additionally, separate resistors (or otherwise resistive elements) may be used to provide heat. The heat may be created by passing current through such a resistor or resistive element. Such resistors and resistive elements heat up and when in close proximity to or even integrated into a part such as a connector will cause at least a localized area of the part to heat up. Such resistive elements may be applied and/or integrated to mounts such as PCBs, cables and connectors such as a flex cable, and potting which is used to suppress electric fields. Such a separate wire, or trace, provided within, in or on such a part, thermally elevates the part, and even the component within which it is comprised. The resistor or resistive element may be located within regions of the part, and thus the component, to achieve the desired heating. Using such a heating element may enable localized heating and thus localized bake of a part, and outgassing of that part, without having to thermally elevate the entire part, let alone the entire component or even chamber in which it is located.

As shown in **FIG. 4****,** the wall 550 defining the corresponding chamber may comprise an exterior wall 551 of the vacuum system. In particular, the wall 550 in which the heater 511, 512 is embedded is an exterior wall 551 of the corresponding chamber 531, 532. An exterior wall 551 is a wall 550 between an external environment and a vacuum environment, the vacuum environment being the environment inside the corresponding chamber comprising at least one respective component.

In an alternative arrangement, the wall 550 defining the corresponding chamber may be an interior wall 552 of the vacuum system. In other words, in an alternative arrangement (not shown in **FIG. 4**) one or more of the heaters may be embedded in an interior wall 552 of the vacuum system, wherein an interior wall 552 is a wall between vacuum environments of different chambers. In the arrangements shown in **FIG. 3 and 4****,** an interior wall 552 separates two different chambers of the vacuum system, in particular an interior wall 552 separates the first chamber 531 and the second chamber 532.

The vacuum system desirably comprises thermal shielding between the different chambers, for example between the first chamber 531 and the second chamber 532. The interior walls of the vacuum system are configured to separate and thermally shield the different chambers. For example, the interior wall 552 separating the first chamber 531 and the second chamber 532 may be thermally insulated. In this way, the transfer of heat between different chambers may be reduced and temperature changes, such as during bake out, may be applied to the different chambers independently. As such, bake out of one chamber may be carried out at a different temperature and/or different time to bake out of another chamber within the vacuum system.

As shown, for example, in **FIG. 3 and 4****,** the thermal control system optionally comprises a thermal sensor 521, 522 configured to thermally sense the temperature in the corresponding chamber 531, 532. In the arrangements of **FIG. 3 and 4****,** the thermal control system comprises a plurality of thermal sensors 521, 522. Each thermal sensor is associated with a corresponding chamber 531, 532. The thermal control system may comprise at least one thermal sensor 521 configured to detect the temperature at or adjacent at least part of the respective component. For example, in the arrangements of **FIG. 3 and 4****,** the second thermal sensor 522 is configured to detect the temperature of the source 201, for example an outgassing part such as a chamber wall or source mounting parts. In this way, during bake out, the thermal control system may monitor the temperature detected by the second thermal sensor 522, determine if a maximum allowable temperature of the source 201 has been reached or exceeded, and if so may control the second heater 512 to reduce the temperature of the second chamber 532. In this way, the temperatures of individual heaters may be controlled in order to maintain the desired temperature of the at least one respective component during bake out.

Optionally, more than one thermal sensor may be associated with the same corresponding chamber. For example, in a chamber housing a plurality of respective components, there may be provided a plurality of thermal sensors each associated with at least one respective component. Alternatively, or additionally, a thermal sensor may be configured to thermally sense the temperature of a corresponding thermal conditioner. For example, one or more heaters of the thermal control system may each be associated with a corresponding thermal sensor configured to detect the temperature at or adjacent to the heater. In this way, it may be possible to monitor the temperatures of the heaters as well as the temperatures of at least one respective component of the corresponding chamber undergoing bake out.

The thermal sensor may be disposed on an interior surface of a wall defining the corresponding chamber. Alternatively, the thermal sensor may be partially or fully embedded within a wall, such as an exterior wall or an interior wall of the chamber or a mount for a component attached or integrated to the wall of the chamber.

In the charged particle systems 40 of **FIG. 3 and 4****,** the thermal control system comprises a thermal controller 500 configured to control the one or more thermal conditioners. In particular, the controller 500 is desirably configured to apply thermal control to achieve bake out of the respective chambers independently. The thermal control may comprise controlling the thermal conditioner (or the different thermal conditioners if more than one thermal conditioner is present). Such thermal control (or the controlling) may comprise: setting the target temperature of the respective heater associated with the respective chamber undergoing bake out. If more than one heater is present, then the different heaters are associated with the chambers (noting that a plurality of heaters may operate on the same chamber) undergoing bake out. The controlled thermal conditioner (or when there are more than one thermal conditioner, the thermal conditioners) may be associated with one or more adjacent chambers, not undergoing bake out. A thermal conditioner associated with a chamber not undergoing bake out may be operated for bake out of the chamber at a different time. The thermal control may be provided based on predetermined predefined target parameters associated with a particular chamber, thermal conditioner and/or respective component. Such a parameter may be at least of one of: a target temperature, component sensitivity, and component operating requirements such as cleaning requirements to maintain contamination levels of the chamber and/or component. Such parameters may at least in part determine the operational frequency such as for ensuring adequate cleanliness of the component. Such contamination may include a level of outgassing. For example, the thermal control may be based on one or more pre-programmed sequences.

The thermal control system desirably comprises a plurality of respective independently controllable thermal conditioners. The plurality of respective independently controllable thermal conditioners desirably comprises a plurality of plurality of respective independently controllable heaters 511, 512.

In the arrangements of **FIG. 3 and 4****,** the plurality of chambers comprises a first chamber 531 and a second chamber 532. The plurality of respective independently controllable heaters 511, 512 comprise a first respective independently controllable heater 511 associated with the first chamber 531 and a second respective independently controllable heater 512 associated with the second chamber 532. The thermal controller 500 is configured to independently control the first respective independently controllable heater 511 to achieve bake out within the first chamber 531. The vacuum is desirably maintained within the first chamber 531 during bake out. Similarly, the thermal controller 500 is configured to independently control the second respective independently controllable heater 512 to achieve bake out within the second chamber 532. The vacuum is desirably maintained within the second chamber 532 during bake out.

The thermal control system is desirably configured such that bake out is local to the chamber associated with the respective independently controllable heater being controlled to achieve bake out. In other words, the thermal control system is desirably configured such that the first chamber 531 may undergo bake out without requiring simultaneous bake out of the second chamber 532, and vice versa. In an arrangement the bake out may be local to a component (which may be a specific component or a target component) within the chamber undergoing bake out. Such bake out may be localised to the target component.

The thermal control may be based on a thermal signal from one or more thermal sensors. For example, a target temperature of the second heater 512 may be reduced if the second thermal sensor 522 detects a temperature exceeding the desired bake out temperature of the second chamber 532. Additionally, or alternatively, the target temperature of the second heater 512 may be reduced if the second thermal sensor 522 detects a temperature exceeding a predetermined threshold temperature based on the maximum temperature the source 201, as the at least one respective component, is able to safely withstand.

The heater may be any type of heater suitable for use in a vacuum environment. For example, the heater may comprise an electrical resistive element, such as a resistive trace. In other words, a length of resistive material may be provided in a dense arrangement, such as a loop, coil, spiral or meander. Using such a form of heating element may help ensure that the intended portion of the part of the component (or even the component) is thermally elevated to optimally bake out the desired regions of the part (and for example the component). The form of the trace may apply heating to the part so as to avoid sensitive regions of the part and the component. Similarly, the cooling element may be any type of cooling element suitable for use in a vacuum environment. For example, the cooling element may be a fluid conduit. The cooling element (such as fluid conduit) may have a length arranged in a loop, coil, spiral, meander or any other sinuous form. The path of the cooling element or heater may be designed to apply the heat load in a distributed manner as intended to apply the heat load to an intended target component or part of the charged particle apparatus.

The plurality of respective independently controllable thermal conditioners may optionally comprise a plurality of plurality of respective independently controllable cooling elements. The cooling elements may be provided in proximity to the more heat sensitive components and/or parts of a chamber. The cooling elements may be used to maintain or even reduce the temperature in a chamber adjacent to a chamber undergoing bake out. Alternatively, or additionally, the cooling elements may be used to locally reduce the temperature of regions (e.g. localised regions) within a chamber undergoing bake out. In this way, certain components and/or parts may undergo relatively fast bake out at high temperatures without all of the components of the same chamber being subjected to the same high temperature. Sensitive components in the same or different chamber may be thermally shielded by operation of the cooling elements.

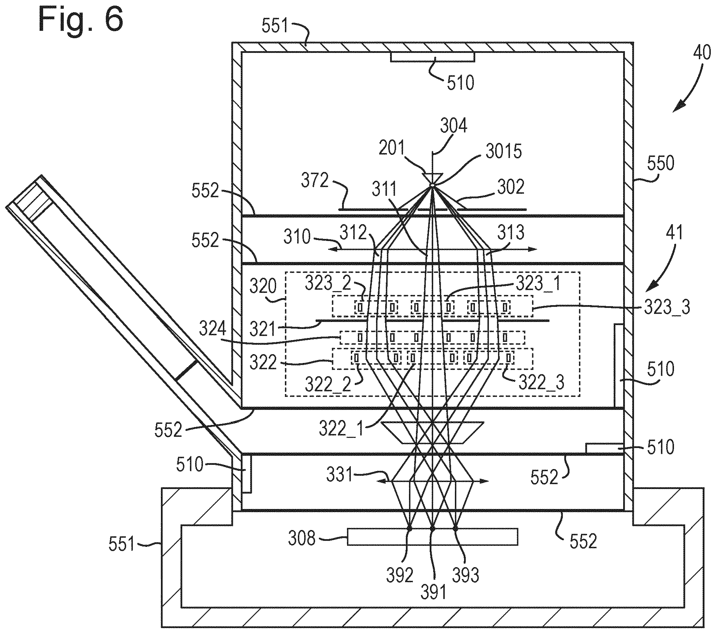

The vacuum system optionally comprises a valve between different adjoining chambers. For example, in the arrangements of **FIG. 3 and 4** a valve may be provided between the first chamber 531 and the second chamber 532. The valve is desirably closed when operating a thermal conditioner in at least one of the adjoining chambers. For example, the valve may be closed during bake out of one of the chambers. The valve may be opened during pump down of the system. Closing the valve may help ensure that any pressure changes within the vacuum chamber are local to the chamber undergoing bake out. One objective of bake out is to remove contamination from a component of the charged particle system 40 such as outgassing material. Outgassing material is typically gaseous and may consist of water and/or hydrocarbons. During outgassing the pressure within the chamber undergoing bake out may increase. Closing the valves connecting the vacuum chamber to adjacent chambers may confine the pressure increase to the chamber undergoing outgassing. The valves may be closed between adjoining chambers undergoing outgassing. This may ensure that the outgassing of one chamber does not unduly influence the pressure in the other chamber. Localizing the pressure changes may restrict or even prevent the contaminating fluid e.g. outgassing from moving into (e.g. migrating) a different chamber. Unless the contamination is removed in maintaining the vacuum, the contamination (and pressure increase) is restricted to the chamber in which it is located. Such valves may be found between adjoining chambers of charged particle systems having multiple chambers such as shown in and described with reference to **FIGs. 6 to 10****.**

The vacuum system is optionally configured to bake out, during pump down. Such bake out during pump down may be applied to a selected chamber (which can be one, some or all of the chambers) or a respective component or selected components in a respective selected chamber. This may decrease the amount of time taken for the charged particle system to return to operation after a service performed at atmospheric pressure. Such bake out would previously have occurred prior to the initiating of pump down for example when removing elements for bake out e.g. in a bake out oven, and/or would previously have occurred for all chambers (e.g. the full vacuum system) during pump down for the full vacuum system.

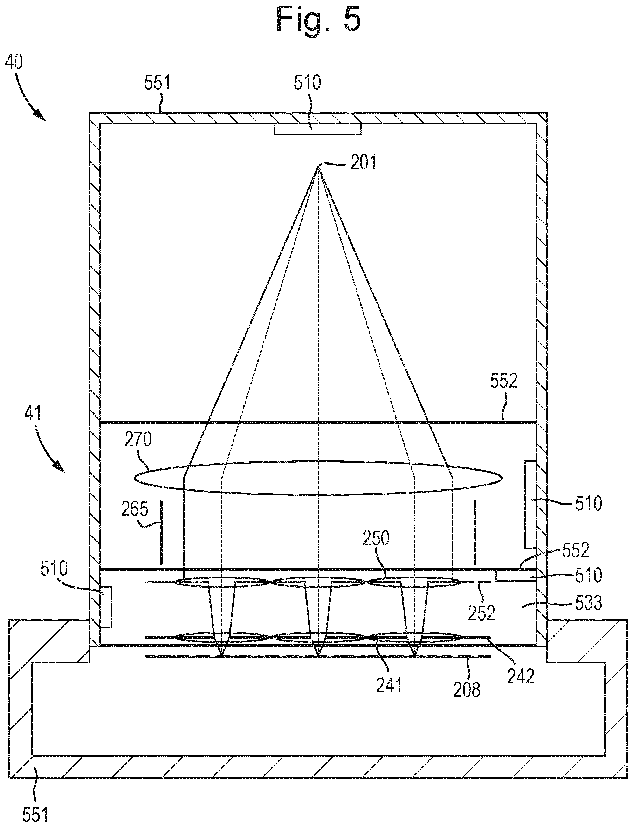

In the embodiment of **FIG. 5****,** the charged particle system 40 comprises a source 201. Features, functions, benefits and advantages of the present invention described in reference to earlier embodiments apply to this embodiment unless statements are made to the contrary. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. For example, as shown in **FIG. 5** in an embodiment the charged particle device 41 comprises an upper beam limiter 252 that defines an array of beam-limiting apertures. The upper beam limiter 252 may comprise a plate (which may be a plate-like body) having a plurality of apertures.

The source 201 is desirably a high brightness thermal field emitter with a good compromise between brightness and total emission current. In the example shown, a collimator is provided upbeam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically, for example wholly electrostatically. The macro-collimator may comprise an electrostatic lens or electrostatic lens arrangement comprising a plurality of electrostatic lens sub-units. The macro collimator 270 may use a combination of magnetic and electrostatic lenses. Desirably, the macro collimator 270 uses only electrostatic lenses.

In the embodiment of **FIG. 5** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 256 comprises a macroscopic multi-pole deflector, for example with 8 poles or more. The macro-scan deflector may be electrostatic or magnetic. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In other embodiments, for example variations of the arrangements shown in and described with reference to **FIG. 5****,** both the macro scan deflector 265 and the scan-deflector array 260 are provided. In such an arrangement, the scanning of the sub-beams over the sample surface may be achieved by controlling the macro scan deflector and the scan-deflector array 260 together, preferably in synchronization. A variation may comprise both the macro collimator 270 and a collimator array, distributing the collimation action through the column. In a variation the scan deflector function may be achieved using a scan deflector array with a deflector for one more sub-beams of the plurality of sub-beams. Such a scan deflector array may be between a control lens array 250 and an objective lens array 241. In a variation the collimating function may be achieved using a collimator array comprising collimating elements for operating on a different sub-beam of the plurality of beams. Such a collimating element may be a deflector. The collimator array may be associated with the control lens array, for example upbeam of a control lens array. An arrangement of a charged particle device with such a collimator array and a scan deflector array is a device of the plurality of devices shown in **FIG. 9****.** That is the functionality of each of the devices of the charged particle device shown and described with reference to **FIG. 9** may correspond to the functionality of the charged particle device shown in and described with reference to **FIG. 5****,** although the macro elements of the collimator and scan deflector are present as a collimator array and scan deflector array instead of macro components.

In other embodiments both a macro scan deflector and a scan-deflector array are provided. In such an arrangement, the scanning of the sub-beams over the sample surface may be achieved by controlling the macro scan deflector and the scan-deflector array together, preferably in synchronization.

The objective lens array assembly may further comprise a beam shaping limiter 242. The beam shaping limiter 242 defines an array of beam-limiting apertures. In an arrangement, the beam shaping limiter 242 is structurally integrated with an electrode of the objective lens array 241. Desirably, the beam shaping limiter 242 is positioned in a region of low electrostatic field strength. Each of the beam-limiting apertures is aligned with a corresponding objective lens in the objective lens array 241.

The electron-optical systems of **FIGs. 5** **&** **9** further comprises a detector (not shown), for example detector 240 as described below in relation to **FIG. 7** (as described further below), desirably the detector may be a detector array.

As shown in **FIG. 5** the charged particle system 40 comprises a vacuum system comprising a plurality of chambers. The chambers are defined by the interior surfaces of exterior walls 551 and interior walls 552 of the vacuum system. The charged particle system 40 of **FIG. 5** further comprises a thermal control system, such as that described above with reference to **FIG. 3 and 4****.** For example, the arrangement of **FIG. 5** comprises a plurality of heaters 510 associated with corresponding chambers of the vacuum system. As shown in **FIG. 5****,** the source 201 may be provided in a separate chamber to the charged particle-optical elements of the charged particle device 41. The chamber housing the source 201 comprises a heater 510. The other chambers may optionally each comprise one or more heaters 510, as shown in **FIG. 5****.** In the example arrangement shown by **FIG. 5****,** the macro scan deflector 265 and the macro collimator 270 are provided within the same chamber. A further chamber includes the control lens array 250 and the objective lens array 241. However, in alternative arrangements, there may be a different number of interior walls 552 and/or the interior walls may be differently positioned such that the components of the charged particle device 41 are differently distributed among the chambers. The sample 208 may be provided on a sample holder or support which may be included within another chamber. The arrangement of the different chambers is selected to demonstrate one suitable arrangement. There may be as many or as few walls as desired, for example located between different components along the charged particle beam path and/or between the source 201 and sample position.

Reference is now made to **FIG. 6****,** which is a schematic diagram of an exemplary multi-beam charged particle device 41 of an assessment apparatus, e.g. the assessment apparatus 100 of **FIG. 1****.** Features of the earlier described embodiments are the same, unless stated to the contrary. Features, functions, benefits and advantages of the present invention described in reference to earlier embodiments apply to this embodiment unless statements are made to the contrary. Similarly features, benefits function and advantages described with reference to the embodiment described with reference to **FIG. 6****,** unless stated to the contrary apply to the earlier mentioned embodiments

As depicted, the charged particle device 41 may comprise an electron source 201, a beam former array 372 (also known as a gun aperture plate, a coulomb aperture array or a pre-sub-beamforming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incident electrons. The electron source 201, the beam former array 372, the condenser lens 310 may be the components of an illumination apparatus comprised by the charged particle-optical device 41. The source converter 320 (also known as a source conversion unit), described in more detail below, and the objective lens 331 may be the components of a projection apparatus comprised by the charged particle-optical device 41.

The electron source 201, the beam former array 372, the condenser lens 310, the source converter 320, and the objective lens 331 are aligned with a primary electron-optical axis 304 of the charged particle-optical device 41. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to a charged particle device 41 with any number of sub-beams such as one, two or more than three. The beam former array 372, in operation, is configured to block off peripheral electrons to reduce the Coulomb effect.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in **FIG. 6****,** in an embodiment the charged particle device 41 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system upbeam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in **FIG. 6****,** in an embodiment the charged particle device 41 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The charged particle device 41 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301. In the current embodiment, these virtual images are projected onto the target 308 by the objective lens 331 and form probe spots 391, 392, 393 thereon. The charged particle device 41 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The image-forming element array 322, the aberration compensator array 324, and the pre-bending deflector array 323 may comprise multiple layers of sub-beam manipulating devices, some of which may be in the form of arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

In an embodiment a beam separator (not shown) is provided. The beam separator may be downbeam of the source converter 320. The beam separator may be, for example, a Wien filter comprising an electrostatic dipole field and a magnetic dipole field. The beam separator may be upbeam of the objective lens 331. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such a Wien filter, a secondary device and/or a secondary projection apparatus may be provided in a single beam assessment apparatus. Additionally and/or alternatively a detection device may be present downbeam of the objective lens, for example facing the sample during operation. In an alternative arrangement a detector device is position along the path of the charged particle beam towards the sample. Such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electrostatic plates may be arranged in series of two or more adjoining plates along the path of the charged particle beam.

Any element or collection of elements may be replaceable or field replaceable within the charged particle-optical device. Such an element or collection of elements may be comprised in a module of the charged particle system 40. Such replaceability means that such a module can be removed and replaced with a replacement module without substantially dismantling the rest of the charged particle system 40, for example even in the field. The one or more electron-optical components in the charged particle-optical device, especially those that operate on sub-beams or generate sub-beams, such as aperture arrays and manipulator arrays may comprise one or more plates each of which may be an electrode or may comprise one or more electrodes per aperture of the array. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

As shown in **FIG. 6** the charged particle system 40 comprises a vacuum system comprising a plurality of chambers. The chambers are defined by the interior surfaces of exterior walls 551 and interior walls 552 of the vacuum system. The charged particle system 40 of **FIG. 6** further comprises a thermal control system, such as that described above with reference to **FIG. 3 and 4****.** For example, the arrangement of **FIG. 6** comprises a plurality of heaters 510 associated with corresponding chambers of the vacuum system. As shown in **FIG. 6****,** the source 201 is provided in a separate chamber to the charged particle-optical elements of the charged particle device 41. A heater 510 is provided to heat the source 201 in order to bake out the source 201. In the example arrangement shown by **FIG. 6****,** the condenser lens 310 is provided in a dedicated chamber, the source converter 320 is provided in an adjacent chamber, and the objective lens 331 is provided in another chamber. The sample 208 may be provided on a sample holder or support which may be included within another chamber.

Certain components may be comprised in a separable or removable module, such as the different features of the source module 320. The electron-optical components may be a series of component arrays with electrically isolating supports which comprise material susceptible to contamination for example outgassing. Such materials may be susceptible to water absorption such as plastic and/or ceramic. Associated with the electron-optical components of the source module may be electronics which may be mounted on a support such as a PCB or potting to contain electric fields. Communications and power may electrically connect the electronics, the electron-optical components and an external controller such as through a feedthrough in the wall of the chamber. A cable such as a flex cable may provide such electrical connections. The module may have actuators to position the electron-optical components relative to the source 201 (or at least a path of the charged particle beams).

Different components may comprise materials which are a source of contamination such as parts for example the electrical cable in comprising a plastic exterior, the electronics mount such as a PCB in comprising a plastic substrate. Such contamination may be outgassing. Bake out may be used to remove and thus suppress outgassing during operation. Outgassing can be suppressed by careful selection of materials to restrict if not avoid the use of materials liable to outgas. However some outgassing from most surfaces in a vacuum chamber is to be expected.

Thermal conditioners may be used to apply bake out heating. Such a part (or component or element) may be additionally part of the module and/or existing parts of the module such as the electronics mounts such as a PCB and the electrical connection such as the flex cable. A PCB may comprise additional resistive traces for example as sinuous traces over a portion of a surface of the PCB that will elevate in temperature when conducting current. A similar arrangement of electric tracing may be incorporated in the potting. Operation of actuators may cause the motors and/or electrical connections to the actuators to generate heat. An electrical cable may be designed to withstand a higher current to emit heat during bake out. Such heaters may be located where heat is most desired during bake out, for example away from heat sensitive electronics. Additionally or alternatively separate thermal conditioners may be used, for example positioned where heat is required during bake out in the module, for example in one or more components that absorb water so as to reduce outgassing during sample assessment. A cooling system may be used to suppress the heat load applied to thermally sensitive components within the module. The cooling system may comprise active and/or passive features. A conduit of the cooling system may be positioned to target elements such as a detector array and the electronics. A path of the conduit may be limited to applying a cooling heat load to such components. Thus heat may be applied and yet restricted to parts of the module where bake out to limit if not prevent outgassing is most desirable.

It should be noted that some designs of thermal conditioner, such as a heater for example a resistive heater may be used as a thermal sensor for temperature measurement when not in use as a heater. Therefore heaters present in existing components may be used for monitoring the temperature of a component for example as a heat sensitive resistive element. The resistive element may be operated as a heater when it or another thermal sensor detects a temperature that the controller determines requires application of heat. Additionally or alternatively, the heater may be a separate heating element for example in contact with or integrated into a component. The heater may operate as a heat sensitive resistant element and so may be operated in a similar manner in monitoring and applying heat.

Components of a charged particle system 40 which may be used in the present invention are described below in relation to **FIG. 7** which is a schematic diagram of a charged particle system 40. The charged particle system 40 of **FIG. 7** may correspond to the charged particle system 40 (which may also be referred to as an apparatus or a tool) mentioned above. Features of the earlier described embodiment are the same, unless stated to the contrary. Features, functions, benefits and advantages of the present invention described in reference to earlier embodiments apply to this embodiment unless statements are made to the contrary. Similarly features, benefits function and advantages described with reference to the embodiment described with reference to **FIG. 7****,** unless stated to the contrary apply to the earlier mentioned embodiments.

The schematic diagram of an exemplary charged particle device, as shown in **FIG. 7** has an objective lens array assembly. The objective lens array assembly comprises the objective lens array 241. The objective lens array 241 comprises a plurality of objective lenses. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam or group of sub-beams in the multi-beam. Each plate defines a plurality of apertures (which may also be referred to as holes). The position of each aperture in a plate corresponds to the position of a corresponding aperture (or corresponding hole) in the other plate (or plates). The corresponding apertures define the objective lenses and each set of corresponding holes therefore operates in use on the same sub-beam or group of sub-beams in the multi-beam. Each objective lens projects a respective sub-beam of the multi-beam onto a sample 208.

The objective lens array assembly further comprises the control lens array 250. The control lenses pre-focus the sub-beams. (e.g. apply a focusing action to the sub-beams prior to the sub-beams reaching the objective lens array 241). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. In an embodiment, the control lens array may be considered to be part of the objective lens array.

In the arrangement of **FIG. 7****,** the objective lens array assembly comprises the scan-deflector array 260. The scan-deflector array 260 comprises a plurality of scan deflectors. Each scan deflector scans a respective sub-beam over, or across, the sample 208. The scan-deflector array 260 may thus comprise a scan deflector for each sub-beam. Each scan deflector may deflect rays in the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. The scan-deflector array 260 is positioned between the objective lens array 241 and the control lens array 250. In the embodiment shown, the scan-deflector array 260 is provided instead of a macro scan deflector, such as an electrostatic scan deflector (not shown). A scan-deflector array 260 may be more spatially compact than a macro scan deflector.

The objective lens array assembly may comprise a detector 240. (Alternatively the detector maybe comprised in the charged particle device 41 without having to be present in the objective lens array assembly). The detector 240 may comprise detector elements (e.g. sensor elements such as capture electrodes). The detector 240 may comprise any appropriate type of detector. For example, the detector elements may be charged based detector configured to detect charge detected with respect to time e.g. as current, scintillators or using semiconductor devices such as PIN elements. The detector 240 may be a direct current detector or an indirect current detector.

The detector 240 may be positioned between the objective lens array 241 and the sample 208. The detector 240 is configured to be the most downbeam feature of the electron-optical device, for example proximate the sample 208. The detector 240 may be very close to the sample 208, for example less than 5mm, preferably between 200 and 10 µm.

The detector 240 may be positioned in the device so as to face the sample 208. Alternatively or additionally, the detector 240 may be positioned elsewhere in the charged particle system 40 such that part of the charged particle device 41 that faces the sample 208 is other than, and thus is not, a detector; such as an electrode of the objective lens arrangement In such an arrangement another element of the electron-optical device may face the sample during operation, for example an electrode plate of the objective lens. In all these arrangements there is a most downbeam element of the electron-optical system, such as detector 240, most proximate to the sample. The most downbeam surface of the most downbeam element may face the sample.

A bottom surface of the detector 240 (or a facing surface of the detector 240 which may face a sample 208 in use, may comprise a substrate on which are provided a plurality of detector elements. Each detector element may surround a beam aperture. The beam apertures may be formed by etching through the substrate. In the arrangement the beam apertures are in a hexagonal close packed array, or alternatively in a rectangular array. The detector elements may be arranged in a rectangular array or a hexagonal array.

In cross section of the detector, the detector elements form the bottommost, i.e. most close to the sample 208, surface of the detector 240. Between the detector elements and the main body of the substrate a logic layer may be provided. At least part of the signal processing system may be incorporated into the logic layer. A wiring layer is provided on the backside of, or within, the substrate and connected to the logic layer by through-substrate vias. The wiring layer can include control lines, data lines and power lines. A printed circuit board and/or other semiconductor chips may be provided on, for example connected to, the backside of detector 240.

The detector 240 may be implemented by integrating a CMOS chip detector into an electrode of the objective lens array 241, such as the bottom electrode of the objective lens array 241. Integration of a detector 240 into the objective lens array 241 or other component of the charged particle device 41 allows for the detection of electrons emitted in relation to multiple respective sub-beams. The CMOS chip may embody the detector it may be orientated to face the sample. In an embodiment, detector elements to capture the secondary charged particles are formed in the surface metal layer of the CMOS device. The detector elements can be formed in other layers. Power and control signals of the CMOS may be connected to the CMOS by the through-silicon vias. A passive silicon substrate with holes shields the CMOS chip from high E-fields, for example providing robustness.

In order to maximize the detection efficiency it is desirable to make the surface of the detector elements as large as possible, so that substantially all the area of the objective lens array 240 (excepting the apertures) is occupied by detector elements. Additionally or alternatively, each detector element has a diameter substantially equal to an array pitch (i.e. of the pitch of the apertures of the aperture array in the electrodes of the objective lens assembly 241). The diameter of each detector element may be less than approximately 600 µm, and preferably between approximately 50 µm and 500 µm. The pitch may be selected depending on the intended distance between the sample 208 and the detector 240. In an embodiment the outer shape of the detector element is a circle, but this can be made a square to maximize the detection area. The diameter of the through-substrate via can be minimized. A typical size of the electron beam is in the order of 5 to 15 µm.

In an embodiment, a single detector element surrounds each beam aperture. In another embodiment, a plurality of detector elements are provided around each beam aperture.

As shown in **FIG. 7** the charged particle system 40 comprises a vacuum system comprising a plurality of chambers. The chambers are defined by the interior surfaces of exterior walls 551 and interior walls 552 of the vacuum system. The charged particle system 40 of **FIG. 7** further comprises a thermal control system, such as that described above with reference to **FIG. 3 and 4****.** For example, the arrangement of **FIG. 7** comprises a plurality of heaters 510 associated with corresponding chambers of the vacuum system. As shown in **FIG. 7****,** the source 201 is provided in a separate chamber to the charged particle-optical elements of the charged particle device 41. In the example arrangement shown by **FIG. 7****,** the condenser lens 231 is disposed within one chamber and the collimator 235 is disposed within an adjacent chamber. The control lens array 250 and detector 240 are disposed within the same chamber. The sample 208 may be provided on a sample holder or support which may be included within another chamber. As described with reference to **FIG. 6** one or more of the components may be comprised in a module which may be replaceable for example field replaceable. Thermal conditioners may be incorporated into existing elements of such a module or be additionally included within the module. The thermal conditioners may be positioned, designed and operated so as to optimize the impact of bake out as required by one or more specific components of the module and for reliable operation of the charged particle system 40. The thermal conditioners may be so configured to achieve bake out without thermally impacting e.g. damaging one or more sensitive elements of the module. Bake out may be achieved to suppress unwanted outgassing during operation, for example driving outgassing (i.e. fluid e.g. gases) during bake out. Having a vacuum chamber designed for one more such modules, bake out may be achieved locally to the vacuum chamber or even one such module. Bake out may be achieved locally to an element (e.g. localized bake out for such an element) of such a module by operation of a thermal conditioner associated with an element liable to outgas such as a support such as a PCB or an electrical connector such as a cable flex. Such application of the present invention may be applied to a component, for example a module of the arrangements shown in and described with reference to **FIGs. 5** **and** **6****.**

**FIG. 8** schematically depicts a charged particle system 40 according to an embodiment. Features that are the same as those described above are given the same reference numerals. For conciseness, such features are not described in detail with reference to **FIG. 8****.** For example, the source 201, the condenser lenses 231, the macro collimator 270, the objective lens array 241 and the sample 208 may be as described above. Features, functions, benefits and advantages of the present invention described in reference to earlier embodiments apply to this embodiment unless statements are made to the contrary. Similarly features, benefits function and advantages described with reference to the embodiment described with reference to **FIG. 8****,** unless stated to the contrary apply to the earlier mentioned embodiments.

As described above, in an embodiment the detector 240 is between the objective lens array 241 and the sample 208. The detector 240 may face the sample 208. Alternatively, as shown in **FIG. 8****,** in an embodiment the objective lens array 241, which comprises the plurality of objective lenses, is between the detector 240 and the sample 208. The detector 240 may have all the features of the earlier described embodiments for example with reference to **FIG. 7****,** except as herein described.

In an embodiment a deflector array 95 is between the detector 240 and the objective lens array 241. In an embodiment the deflector array 95 comprises a Wien filter (or even a Wien filter array) so that deflector array may be referred to as a beam separator. The deflector array 95 is configured to provide a magnetic field to disentangle the charged particles projected to the sample 208 from the secondary electrons from the sample 208. However, it is preferable that the system comprises electrostatic components, rather than magnetic components.

In an embodiment the detector 240 is configured to detect signal particles by reference to the energy of the charged particle, i.e. dependent on a band gap. Such a detector may be a semiconductor based detector such as a PIN detector or a scintillator, which may be optically connected to a photonic converter or photon to electron converter). Such a detector 240 may be called an indirect current detector. The secondary electrons emitted from the sample 208 gain energy from the fields between the electrodes. The secondary electrodes have sufficient energy once they reach the detector 240.

The control lens array 250 may be present, for example in the same module as an objective lens array 241, i.e. forming an objective lens array assembly or, in one type of terminology, as part of the objective lens array, or it may be in a separate module.

In some embodiments for example of any of the embodiments described with reference to and shown in **FIGs 7****,** **8** **and** **9****,** one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment system, and/or as part of an electron-optical arrangement. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane). In a different embodiment, aberration correctors positioned in, or directly adjacent to, the intermediate foci (or intermediate image plane) comprise correctors to correct for the source 201 appearing to be at different positions for different beams. Correctors can be used to correct macroscopic aberrations resulting from the source that prevent a good alignment between each sub-beam and a corresponding objective lens. In some embodiments, aberration correctors are integrated with, or directly adjacent to, the objective lens array 241. In an embodiment, these aberration correctors reduce one or more of the following: field curvature; focus error; and astigmatism. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

Additionally or alternatively, one or more scanning deflectors (not shown) may be integrated with, or directly adjacent to, the objective lens array 241 for scanning the sub-beams 211, 212, 213 over the sample 208. In an embodiment, the scanning deflectors described in US 2010/0276606, which document is hereby incorporated by reference in its entirety, may be used.

As shown in **FIG. 2** (when read in context of the charged particle devices 41 as depicted in and described with respect to **FIGs 5 to 9**), in an embodiment the projection assembly 60 optionally comprises an optical system 63. In an embodiment, the projection system 60 comprises a light source 61. The light source 61 is configured to emit the light beam 62. As mentioned above the projection assembly 60 is used to illuminate a light beam 62 on the sample 208 so as to control the accumulated charges due to effects such as photoconductivity, photoelectric, or thermal effects; and thus regulate the accumulated charges on the sample. In an arrangement, the light may be directed between the facing surface of the electron-optical device and the sample surface, for example by reflecting off such surfaces until it is incident on the sample at the same locations as the primary beams. In an arrangement the path of the light from the light source 61 may be at least partly through the charged particle device 41. For example the path of the light may enter the charged particle device upbeam of the objective lens array 240 and be reflected by a reflecting surface 65 within the charged particle device 41 towards the sample for example through the apertures defined in the plates defining the objective lens array and other charged particle-optical elements of the charged particle device. In an embodiment the light source may be proximate the source 201, for example around the source 201 and or adjacent the source so that the path of the light towards the sample passes through all the elements of the charged particle device 41. In another embodiment, the path of the light is through light guides from the light source to the objective lens array for example as disclosed in EP 22204243.4 filed on 27 October 2022 which is hereby incorporated by reference at least so far as the disclosure of optical light guides for outcoupling light towards a sample. Additionally or alternatively the light may be outcoupled proximate or from apertures defined in the surface of the element facing the sample.

As shown in **FIG. 8** the charged particle system 40 comprises a vacuum system comprising a plurality of chambers. The chambers are defined by the interior surfaces of exterior walls 551 and interior walls 552 of the vacuum system. The charged particle system 40 of **FIG. 8** further comprises a thermal control system, such as that described above with reference to **FIG. 3 and 4****.** For example, the arrangement of **FIG. 8** comprises a plurality of heaters 510 associated with corresponding chambers of the vacuum system. As shown in **FIG. 8****,** the source 201 is provided in a separate chamber to the charged particle-optical elements of the charged particle device 41. In the example arrangement shown by **FIG. 8****,** the condenser lens 231 and the macro collimator 270 is disposed within the same chamber and the detector 240 is disposed within an adjacent chamber. The deflector array 95 is disposed within another chamber and the objective lens array 241 is disposed within a further chamber. The sample 208 may be provided on a sample holder or support which may be included within another chamber.

The arrangement shown in and described with reference to **FIG. 8** may have one or more electrical components which may be in respective modules as described with reference to the charged particles systems of **FIGs. 5****,** **6** **and** **7****.** Such components and, if present, module, may be comprise features as described herein and operated in the manner described here in to achieve localised bake out of a part of the charged particle system shown in **FIG. 8****.**

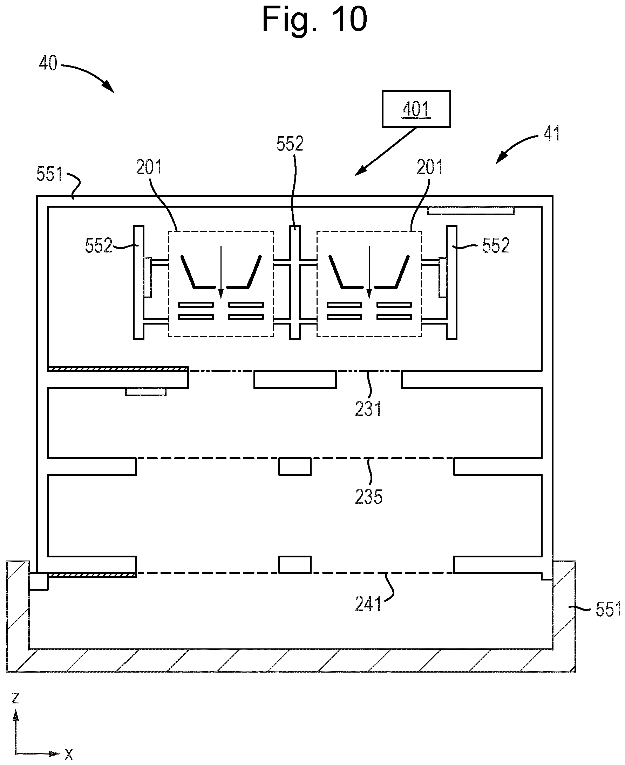

The charged particle system 40 may comprise a plurality of sources 201, for example as shown in **FIG. 9** **and** **10****.** Features, functions, benefits and advantages of the present invention described in reference to earlier embodiments apply to this embodiment unless statements are made to the contrary. Similarly features, benefits function and advantages described with reference to the embodiment described with reference to **FIGs. 9** **&** **10****,** unless stated to the contrary apply to the earlier mentioned embodiments. As described above, the arrangement shown in **FIG. 9** is a charged particle system comprising a plurality of charged particle devices 41 each with a respective source 201. (In a different embodiment the charged particle devices 41 may comprise a respective source 201). The charged particle device 41 may be any of the charged particle devices shown and depicted with reference to **FIGs. 5****,** **7** **and** **8****.** However, the arrangement shown in **FIG. 9** is a similar arrangement to that shown in and described with reference to **FIG. 5** in having a collimator array and a scan deflector array proximate and for example integrated with the objective lens array and the control lens array.

Each source 201 is configured to emit a respective beam of charged particles. The charged particle systems 40 of **FIG. 9** **and** **10** comprise a respective charged particle device 41 for each respective source 201. The charged particle systems comprise walls between chambers of adjoining electron-optical devices. In particular, in the arrangements shown in **FIG. 9** **and** **10****,** the walls between chambers of adjoining electron-optical devices are interior walls 552. The interior walls 551 may define different chambers for respective charged particle devices 41. There is desirably thermal shielding between each source 201 of the plurality of sources in the charged particle system 40. Thus there may be thermal shielding between the source 201 and the respective charged particle device. Additionally, or alternatively, there may be thermal shielding between chambers of adjoining charged particle devices 41. In other words, there may be thermal shielding between a source 201 and an adjacent source 201, and there may be thermal shielding between the charged particle devices 41 associated with adjacent sources 201. The thermal shielding may be provided by an internal wall 552. The sources 201 may each disposed within different chambers.

The arrangement shown in and described with reference to **FIGs. 9** **&** **10** may have one or more electrical components which may be in respective modules as described with reference to the charged particles systems of **FIGs. 5****,** **6****,** **7** **and** 8. Such components and, if present, module, may comprise features as described herein and operated in the manner described herein to achieve localised bake out of a part of the charged particle system shown in **FIG. 9****.**

In an embodiment the charged particle device 41 may comprise alternative and/or additional components on the charged particle path, such as lenses and other components some of which have been described earlier with reference to **FIG. 1** and **6****.** Examples of such arrangements are shown in **FIG. 9** which is described in further detail later. A detector is provided to detect charged particles emitted by the sample. The detector may be integrated into the objective lens. The detector may be on the bottom surface of the objective lens so as to face a sample in use. The detector may comprise an array, for example of detector elements, which may correspond to the array of the beamlets of the multi-beam arrangement. The detectors (or detector elements) in the detector array may generate detection signals that may be associated with the pixels of a generated image.

**FIG. 9** is a schematic diagram of another design including a plurality of exemplary charged particle-optical devices 41. Each charged particle device 41 may comprise a source 201 and one or more electron-optical assemblies. Alternatively, the electron-optical apparatus that comprises the charged particle device 41 may comprise the source 201. The charged particle device 41 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). These components may take the form as described with reference to the electron device 41 shown and described with reference to **FIGs. 5****,** **6** **and** **7****.**

The collimator element array 271 is provided downbeam of the upper beam limiter 252. Each collimator element collimates a respective sub-beam. The collimator element array 271 may be formed using types of processing techniques so as to be spatially compact. In some embodiments, exemplified in **FIG. 9****,** the collimator element array 271 is the first deflecting or focusing electron-optical array element in the beam path downbeam of the source 201.

In an embodiment, as exemplified in **FIG. 9****,** a charged particle-optical device array 500 is provided. The array 500 may comprise a plurality of any of the charged particle-optical devices described herein. Each of the charged particle-optical devices focuses respective multi-beams simultaneously onto different regions of the same sample.

Any number of charged particle-optical devices may be used in the array 500. Each charged particle-optical device in the array 500 may be configured in any of the ways described herein when referring to a single charged particle-optical device. Details of such an arrangement is described in EPA 20184161.6 filed 6 July 2020 which, with respect to how the objective lens is incorporated and adapted for use in the multi-device arrangement is hereby incorporated by reference.

As shown in **FIG. 9** the charged particle system 40 comprises a vacuum system comprising a plurality of chambers. The chambers are defined by the interior surfaces of exterior walls 551 and interior walls 552 of the vacuum system. The charged particle system 40 of **FIG. 9** further comprises a thermal control system, such as that described above with reference to **FIG. 3 and 4****.** For example, the arrangement of **FIG. 9** comprises a plurality of heaters 510 associated with corresponding chambers of the vacuum system. As shown in **FIG. 9****,** the sources 201 are provided in a separate chamber to the charged particle-optical elements of the charged particle device 41. In the example arrangement shown by **FIG. 9****,** the sources 201 are all provided within the same chamber with interior walls separating the beams emitted from each of the sources 201. In an alternative arrangement, the interior walls 552 may extend to the external wall 511. In other words, in an alternative arrangement, each source 201 may be provided within a separate chamber of the vacuum system. The chamber housing the sources 201 desirably comprises a plurality of heaters. In particular, at least one heater may be provided to heat each of the sources 201 during bake out of the sources 201. The walls of the chamber housing the sources 201 may optionally comprise or consist of getter materials (for example the walls in effect provide a pump for maintaining the vacuum in the chamber). The components of each charged particle device 41 may be provided in one or more separate chambers. In other words, the components of each charged particle device 41 may have one or more dedicated chambers not shared with the other charged particle devices 41 of the charged particle system 40. Each charged particle device 41 may be associated with a corresponding, respective source 201.

**FIG. 10** provides a side view (such as cross-section in the direction of a beam path or the electron-optical axis) of a charged particle system 40 including a charged particle device 41 (or multi-device). As an exemplary arrangement, the charged particle system 40 of **FIG. 10** provides an arrangement of four beam areas arranged in two rows of two beam areas. The charged particle system 40 of **FIG. 10** comprises a plurality of charged particle beam sources 201. The charged particle system 40 of **FIG. 10** comprises four sources 201 (two of which are visible). The walls defining the vacuum chamber comprising the module may be compromised in a module such as source array module. Such a source array module may be replaceable. The different charged particle devices 41 may comprise a collimator 235, a condenser lens array 231, and an objective lens array 241. The collimator is configured to collimate the beams of the beam grid, for example as collimated beams towards the sample, from a diverging array of beams from the condenser lens array 231. As mentioned the charged particle device comprise electron-optical components for example as described with reference to and shown in **FIGs. 5****,** **7** **and** **8** or variations thereof.

As shown in **FIG. 10** the charged particle system 40 comprises a vacuum system comprising a plurality of chambers. The chambers are defined by the interior surfaces of exterior walls 551 and interior walls 552 of the vacuum system. The charged particle system 40 of **FIG. 10** further comprises a thermal control system, such as that described above with reference to **FIG. 3 and 4****.** For example, the arrangement of **FIG. 10** comprises a plurality of heaters 510 associated with corresponding chambers of the vacuum system. As shown in **FIG. 10****,** each source 201 may be provided in a separate chamber. Interior walls 552 may separate the different sources 201 of the charged particle system 40. The separate chambers may be operated in groups or separately to achieve local bake out for example in the manner described with reference each and any of **FIGs. 5 to 8****.** Localized bake out of a component and/or of a specific chamber may be achieved in the charged particle device shown in and described with references to **FIGs. 9** **and** **10****.**

Although disclosure herein appears limited to systems in which a plurality of beams are directed to a sample simultaneously (for example a multibeam assessment system), the present invention is applicable to a single beam system. Such a single beam system may comprise a source, a condenser lens, a detector, a scan deflector and an objective lens with other electron-optical elements such as correctors. A single beam system may have similar electron-optical components and architectures as the charged particle assessment system shown in and described with reference to **FIG. 6****,** except, for example with a single beam and without components for generating and/or operating on different beams separately such as the source converter for a plurality of beams The charged particle system may have one or more chambers in which the electron-optical components may be locally bake out using thermal conditioners (such as cooling elements and heaters) thermal shields as herein described. Further, in having multiple chambers, different parts (for example different components of) the charged particle device may be locally baked out. Such bake out may assist in managing and suppressing contamination such as outgassing. Such bake out may avoid applying excess thermal load to sensitive components, for example extending their lifetime.

In this text reference is made to electron-optical plates in which one more apertures are defined. Such a plate may be manufactured using processing suitable for manufacturing microelectromechanical systems (MEMS). Such a charged particle-optical component or device may be referred to as a MEMS. MEMS are miniaturized mechanical and electromechanical elements that are made using microfabrication techniques. The pre-bending deflector array 323 may be a MEMS. In an embodiment the charged particle device 41 comprises apertures, lenses and deflectors which may be formed as MEMS such as the condenser lens array, the control lens array, the objective lens array, the collimator array, scan deflector arrays, corrector arrays and even features of the detector array. Further such electron optical elements such as the condenser lenses, objective lenses and/or detector may be formed as MEMS or CMOS devices.

One or more electric power sources may be provided as a power supply to the electron-optical element of each and every component and element pf the different charged particle systems herein disclosed. Potentials may be applied to the different electrodes of the different electrostatic elements. Current may be applied to the referenced magnetic components. Such components and elements include, for example: the macro-condenser lens, the source, the scan deflector, the detector, the electrodes of the control lenses of the control lens array 250, the objective lenses of the objective lens array 241, the elements of the collimator array, the lenses of the condenser lens array, the scan deflector array and corrector elements.

The descriptions above are intended to be illustrative, not limiting. Thus, it will be apparent to one skilled in the art that modifications may be made as described without departing from the scope of the claims and clauses set out below.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. A charged particle system for emitting a beam of charged particles towards a sample for inspecting the sample, the system comprising: a source configured to emit a beam of charged particles; a charged particle device configured to project the beam of charged particles towards a sample, the charged particle device comprising a plurality of charged particle-optical elements along the path of the beam of charged particles; a support configured to support the sample; a vacuum system with a plurality of chambers of which different chambers are configured to comprise at least one respective component comprising at least one of the source and one or more charged particle-optical elements; and a thermal control system configured to bake out the different chambers independently.
Clause 2. The system of clause 1, wherein the thermal control system comprises a thermal conditioner, such as a heater associated with a corresponding chamber of the vacuum system.
Clause 3. The system of clause 2, wherein the heater is directly connected to a chamber of the vacuum system, for example at least partly to a wall of the chamber desirably the wall defining the corresponding chamber is at least part of an exterior wall of the vacuum system, desirably an exterior wall is between an external environment and vacuum environment comprising at least one respective component..
Clause 4. The system of clause 2 or 3, wherein the heater is disposed within an interior of the corresponding chamber of the vacuum system, desirably the interior is at least partly defined by an interior surface of a wall (e.g. an interior wall) defining the corresponding chamber
Clause 5. The system of any of clauses 2 to 4, wherein the heater is at least partially embedded within a wall defining the corresponding chamber of the vacuum system.
Clause 6. The system of clause 5, wherein the heater is flush with an interior surface of the wall defining the corresponding chamber of the vacuum system.
Clause 7. The system of clause 5, wherein the heater is completely embedded within the wall defining the corresponding chamber of the vacuum system.
Clause 8. The system of any of clauses 5 to 7, wherein the wall defining the corresponding chamber is an exterior wall of the vacuum system, desirably an exterior wall is between an external environment and vacuum environment comprising at least one respective component.
Clause 9. The system of any of clauses 5 to 7, wherein the wall defining the corresponding chamber is an interior wall of the vacuum system desirably an interior wall is between vacuum environments of different chambers that respectively comprising at least one respective component.
Clause 10. The system of clause 9, wherein the interior wall separates two different chambers of the vacuum system.
Clause 11. The system of any of clauses 2 to 10, wherein heater is configured to heat at least part of at least one respective component within the corresponding chamber, desirably the at least part of the at least respective component is heat resistant.
Clause 12. The system of clause 11, wherein the thermal control system comprises a thermal sensor, desirably the thermal sensor is configured to thermally sense the temperature of a least part of the respective component.
Clause 13. The system of either of clauses 11 and 12, wherein the at least one respective component comprises at least one of: the source, the support, and at least one of the charged particle-optical elements.
Clause 14. The system of any of clauses 2 to 13, wherein the thermal control system comprises a thermal sensor, desirably the thermal sensor is configured to thermally sense the temperature of the thermal conditioner e.g. heater.
Clause 15. The system of any of clauses 2 to 14, wherein the thermal control system comprises a thermal controller configured to control the thermal conditioner.
Clause 16. The system of clause 15, for example when dependent on clause 12 or 14, wherein the controller is configured to apply thermal control to achieve bake out, desirably by controlling the thermal conditioner, desirably based on a thermal signal from the thermal sensor.
Clause 17. The system of any of clauses 15 to 16, wherein the thermal control system comprises a plurality of respective independently controllable thermal conditioners, desirably the plurality of respective independently controllable thermal conditioners comprising a plurality of plurality of respective independently controllable heaters.
Clause 18. The system of clause 17, wherein the plurality of chambers comprises a first chamber and a second chamber, wherein the plurality of respective independently controllable heaters comprise a first respective independently controllable heater associated with the first chamber and a second respective independently controllable heater associated with the second chamber.
Clause 19. The system of clause 18, wherein the thermal controller is configured to independently control the first respective independently controllable heater to achieve bake out within the first chamber, desirably wherein the vacuum is maintained within the first chamber during bake out.
Clause 20. The system of clause 18 or 19, wherein the thermal controller is configured to independently control the second respective independently controllable heater to achieve bake out within the second chamber, desirably wherein the vacuum is maintained within the second chamber during bake out.
Clause 21. The system of clause 19 or 20, wherein the thermal control system is configured such that bake out is local to the chamber associated with the respective independently controllable heater being controlled to achieve bake out.
Clause 22. The system of clause 21, wherein the respective independently controllable heater is disposed to apply heat to locally bake out a component disposed within the chamber associated with the respective independently controllable heater being controlled to achieve bake out.
Clause 23. The system of any of clauses 18 to 22, wherein the thermal controller is configured to independently control each of the plurality of respective independently controllable heaters.
Clause 24. The system of any of clauses 2 to 23, wherein the thermal conditioner is a heater, wherein the heater comprises an electrical resistive element, desirably a resistive trace.
Clause 25. The system of any of the preceding clauses, wherein the vacuum system comprises thermal shielding between the different chambers.
Clause 26. The system of clause 25, wherein interior walls of the vacuum system are configured to separate and thermally shield the different chambers.
Clause 27. The system of any of the preceding clauses, wherein the source is in a different chamber than the one or more charged particle-optical elements.
Clause 28. The system of any of the preceding clauses, further comprising a valve between different adjoining chambers, desirably the valve is closed when operating a thermal conditioner in at least one of the adjoining chambers.
Clause 29. The system of any of the preceding clauses, wherein the charged particle device is configured to convert the charged particle beam emitted from the source into a plurality of sub-beams and to direct each sub-beam towards the sample.
Clause 30. The system of any of the preceding clauses, comprising a plurality of sources, wherein each source is configured to emit a respective beam of charged particles, desirably the system comprises a respective charged particle device for each respective source, desirably walls between chambers of adjoining electron-optical devices being an interior wall.
Clause 31. The system of clause 30, further comprising thermal shielding between each source and/or between chambers of adjoining electron-optical devices.
Clause 32. The system of clause 31, wherein the sources are each disposed within different chambers.
Clause 33. The system of any of the preceding clauses, wherein the vacuum system is configured to bake out during pump down, for example at least selectively in a chamber in which the corresponding heater is operated.
Clause 34. A method of baking out a charged particle system, wherein the charged particle system comprises: a source configured to emit a beam of charged particles; a charged particle device configured to project the beam of charged particles towards a sample, the charged particle device comprising a plurality of charged particle-optical elements along the path of the beam of charged particles; a vacuum system with a plurality of chambers of which different chambers comprise at least one respective component comprising at least one of the source and one or more charged particle-optical elements; and a thermal control system configured to bake out the different chambers; wherein the method comprises controlling the thermal control system to bake out different chambers independently.
Clause 35. A method of baking out a charged particle system comprising a plurality of vacuum chambers each comprising a different component of the charged particle system, and a thermal conditioner associated with each component so as to thermally condition at least part of the respective component, the method comprising: controlling the thermal conditioners to heat the at least part of the respective component of the charged particle system, so that different thermal conditioners are operated independently of each other for bake out of the respective components.
Clause 36. The method of clause 35, wherein the thermal conditioning of the different thermal conditioners occurs in different chambers desirably so that bake out of different chambers is independent of each other.
Clause 37. The method of clause 35 or 36, the charged particle system comprising a valve between adjoining vacuum chambers, wherein the method comprises closing a valve between adjoining chambers of which at least one chamber comprises a component undergoing bake out.
Clause 38. The method of any of clauses 35 to 37, the charged particle system comprising a thermal sensor system for monitoring different parts of the charged particle system and the method comprising receiving monitoring signals from the thermal sensor system, wherein the controlling of the thermal conditioners is dependent on the received monitoring signals.
Clause 39. The method of clause 38, the sensor system comprising a thermal sensor associated with a respective component and/or thermal conditioner, the method further comprising transmitting monitoring signals from the respective thermal sensor, desirably the controlling comprising controlling the respective thermal conditioner dependent on the monitoring signal from the respective thermal sensor.
Clause 40. The method of any of clauses 34 to 39, wherein the charged particle system is a charged particle system according to any one of clauses 1 to 33.

## Claims

1. A charged particle system for emitting a beam of charged particles towards a sample for inspecting the sample, the system comprising:
a source configured to emit a beam of charged particles;
a charged particle device configured to project the beam of charged particles towards a sample, the charged particle device comprising a plurality of charged particle-optical elements along the path of the beam of charged particles;
a support configured to support the sample;
a vacuum system with a plurality of chambers of which different chambers are configured to comprise at least one respective component comprising at least one of the source and one or more charged particle-optical elements; and
a thermal control system configured to bake out the different chambers independently.

2. The system of claim 1, wherein the thermal control system comprises a thermal conditioner, such as a heater associated with a corresponding chamber of the vacuum system.

3. The system of claim 2, wherein the heater is directly connected to a chamber of the vacuum system, for example at least partly to a wall of the chamber desirably the wall defining the corresponding chamber is at least part of an exterior wall of the vacuum system, desirably an exterior wall is between an external environment and vacuum environment comprising at least one respective component.

4. The system of claim 2 or 3, wherein the heater is disposed within an interior of the corresponding chamber of the vacuum system, desirably the interior is at least partly defined by an interior surface of a wall (e.g. an interior wall) defining the corresponding chamber.

5. The system of claim 4, wherein the wall defining the corresponding chamber is an interior wall of the vacuum system desirably an interior wall is between vacuum environments of different chambers that respectively comprising at least one respective component, optionally .
the interior wall separates two different chambers of the vacuum system.

6. The system of any of claims 2 to 5, wherein heater is configured to heat at least part of at least one respective component within the corresponding chamber, desirably the at least part of the at least respective component is heat resistant.

7. The system of claim 6, wherein the thermal control system comprises a thermal sensor, desirably the sensor is configured to thermally sense the temperature of at least one of a least part of the respective component and of the thermal conditioner e.g. heater.

8. The system of any of claims 2 to 7, wherein the thermal control system comprises a thermal controller configured to control the thermal conditioner and which is is configured to apply thermal control to achieve bake out, desirably by controlling the thermal conditioner, desirably based on a thermal signal from the thermal sensor.

9. The system of claim 8, wherein the thermal control system comprises a plurality of respective independently controllable thermal conditioners, desirably the plurality of respective independently controllable thermal conditioners comprising a plurality of plurality of respective independently controllable heaters.

10. The system of claim 9, wherein the plurality of chambers comprises a first chamber and a second chamber, wherein the plurality of respective independently controllable heaters comprise a first respective independently controllable heater associated with the first chamber and a second respective independently controllable heater associated with the second chamber.

11. The system of any of claims 2 to 10, wherein the thermal conditioner is a heater, wherein the heater comprises an electrical resistive element, desirably a resistive trace.

12. The system of any of the preceding claims, wherein the vacuum system comprises thermal shielding between the different chambers.

13. The system of any of the preceding claims, further comprising a valve between different adjoining chambers, desirably the valve is closed when operating a thermal conditioner in at least one of the adjoining chambers.

14. The system of any of the preceding claims, wherein the vacuum system is configured to bake out during pump down, for example at least selectively in a chamber in which the corresponding heater is operated.

15. A method of baking out a charged particle system comprising a plurality of vacuum chambers each comprising a different component of the charged particle system, and a thermal conditioner associated with each component so as to thermally condition at least part of the respective component, the method comprising:
controlling the thermal conditioners to heat the at least part of the respective component of the charged particle system, so that different thermal conditioners are operated independently of each other for bake out of the respective components.
